# EUROPÄISCHE PATENTANMELDUNG

(11) **EP 4 780 182 A2**
(43) Veröffentlichungstag der Anmeldung: **22.07.2026**
(21) Anmeldenummer: 26175906.2
(22) Anmeldetag: 11.12.2018
(51) Int. Cl.: H10K 71/80

(54) **VERFAHREN ZUM HERSTELLEN EINES SEMITRANSPARENTEN DISPLAYS SOWIE EIN SEMITRANSPARENTES DISPLAY**

(30) Priorität: 12.12.2017 DE 102017129524
(62) Teilanmeldung aus: 18819086.2
(71) Anmelder: Fraunhofer-Gesellschaft zur Förderung der angewandten Forschung e.V., 80686 München (DE)
(72) Erfinder: RICHTER, Bernd, 80686 München (DE); WARTENBERG, Philipp, 80686 München (DE); BRENNER, Stephan, 80686 München (DE); KIRCHHOFF, Volker, 80686 München (DE); VOGEL, Uwe, 80686 München (DE)
(74) Vertreter: Pfitzner, Hannes

(57) **Zusammenfassung**

Semitransparentes Display, umfassend: einen Restverbund, der einen Silizium-auf-Isolator-Wafer (SOI-Wafer) mit einem Pixelbereich und einem neben dem Pixelbereich angeordneten Kontaktbereich aufweist, wobei das Silizium-Substrat des SOI-Wafers von einer Rückseite des SOI-Wafers entfernt ist; eine auf einer Vorderseite des SOI-Wafers abgeschiedene elektromagnetische Strahlung emittierende Schicht; eine oberhalb der elektromagnetische Strahlung emittierenden Schicht aufgetragene transparente Deckschicht; einen Verdrahtungsträger, wobei der Verdrahtungsträger eine Leiterplatte mit einer Ausnehmung mindestens in dem Pixelbereich aufweist; und eine Vielzahl von elektrisch leitfähigen Verbindungen, die zwischen dem Kontaktbereich des SOI-Wafers und dem Verdrahtungsträger von der Rückseite des SOI-Wafers angeordnet sind und einen Bump-Bond oder ein Drahtbond oder eine anisotrop leitfähige Klebestelle aufweisen; wobei der Pixelbereich eine Vielzahl von Teilbereichen aufweist, in denen sich keine Schaltungselemente und keine elektrisch leitfähigen Elemente befinden, wobei ferner die Teilbereiche erlauben, dass Licht, welches mit einem menschlichen Auge erfassbar ist, von einer Vorderseite der semitransparenten Anzeige zu einer Rückseite der semitransparenten Anzeige hindurchstrahlen kann.

## Beschreibung

Die Erfindung betrifft ein Verfahren zum Herstellen eines semitransparenten Displays sowie ein semitransparentes Display. Unter einem semitransparenten Display im Erfindungssinn ist ein Display zu verstehen, welches eine Vielzahl von ersten Oberflächenbereichen umfasst, innerhalb denen Licht, welches mit einem menschlichen Auge erfassbar ist, von beiden Seiten des Display durch das Display hindurchstrahlen kann. Des Weiteren umfasst ein semitransparentes Display eine Vielzahl von zweiten Oberflächenbereichen, innerhalb denen Licht, welches mit einem menschlichen Auge erfassbar ist, nicht durch das Display hindurchstrahlen kann.

Displays erlangen eine zunehmende Bedeutung für das Darstellen von Informationen. Sollen derartige Informationen beispielsweise beim Tragen von Brillen oder beim Benutzen von Ferngläsern in den Sichtbereich einer Person eingeblendet werden, sind transparente bzw. semitransparente Displays von Vorteil.

Als Basis zum Herstellen eines Displays wird oftmals ein aus dem Stand der Technik bekannter Wafer verwendet, bei welchem auf einem Siliziumsubstrat eine Schicht aus einem elektrisch nicht leitendem Material abgeschieden ist. Dabei verleiht das Siliziumsubstrat dem Wafer seine mechanische Stabilität und stellt für nachfolgende veranschaulichende Beschreibungen die Rückseite eines solchen Wafers dar. Die Schicht aus elektrisch nicht leitendem Material weist wiederum eine Vielzahl nebeneinander angeordnete siliziumbasierte Aktivgebiete auf, innerhalb denen Transistoren bzw. elektrische Schaltungen ausgebildet sind. Diese Transistoren bzw. elektrische Schaltungen können zum Ansteuern der einzelnen Pixel des Displays verwendet werden. Aufgrund des Anordnens von siliziumbasierten Aktivgebieten auf oder innerhalb einer Isolatorschicht werden eine solche Technologie und ein solcher Wafer auch mit dem englischen Fachbegriff "Silizium-On-Insulator" oder verkürzt "SOI" verknüpft. Ein SOI-Wafer weist ferner auch noch mindestens eine oberhalb der Aktivgebiete angeordnete Schicht auf, die meist aus einem transparenten Oxid besteht, innerhalb der elektrisch leitfähige Verbindungen zwischen den Anschlüssen der elektrischen Schaltungen aus den siliziumbasierten Aktivgebieten ausgebildet sind. Oftmals sind auch bei einem SOI-Wafer mehrere solcher Oxidschichten übereinander abgeschieden, innerhalb denen dann mehrere Verdrahtungsebenen übereinander ausgebildet sind.

Bezogen auf die Oberfläche eines SOI-Wafers, der zum Herstellen eines Displays verwendet wird, teilt sich diese meistens in mindestens einen Pixelbereich und mindestens einen Kontaktbereich auf, wobei nachfolgend innerhalb des Pixelbereichs das bilddarstellende Display und innerhalb des Kontaktbereiches elektrisch leitfähige Verbindungen zu externen Bauelementen ausgebildet werden. Schon wegen des Silizium-Substrates sind SOI-Wafer üblicherweise nichttransparent bezüglich Licht, welches mit einem menschlichen Auge erfasst werden kann.

In US 005317236 A sind Verfahren zum Herstellen eines semitransparenten LCD-Displays beschrieben, bei welchen SOI-Wafer als Basis für den Displayaufbau verwendet werden, auf welche eine elektrolumineszierende Schicht und eine Gegenelektrodenschicht abgeschieden werden. Um eine Transparenz des Displays zu erlangen wird vorgeschlagen, das Silizium-Substrat des SOI-Wafers zu entfernen und durch ein transparentes Substrat wie beispielsweise Glas zu ersetzen. Nachteilig wirkt sich hierbei aus, dass elektrisch leitfähige Verbindungen vom Kontaktbereich des SOI-Wafers zu anderen Bauteilen, wie beispielsweise einen Verdrahtungsträger, nur von der Vorderseite des SOI-Wafers hergestellt werden können, was deren Einsatzmöglichkeiten einschränkt.

Der Erfindung liegt daher das technische Problem zugrunde, ein Verfahren zum Herstellen eines semitransparenten Displays und ein solches semitransparentes Display zu schaffen, mittels denen die Nachteile aus dem Stand der Technik überwunden werden können. Insbesondere soll es mit dem erfindungsgemäßen Verfahren und beim erfindungsgemäßen Display auch möglich sein, rückseitige Kontaktierungsmöglichkeiten zu anderen Bauelementen auszubilden.

Die Lösung des technischen Problems ergibt sich durch Gegenstände mit den Merkmalen der Patentansprüche 1 und 13. Weitere vorteilhafte Ausgestaltungen der Erfindung ergeben sich aus den abhängigen Ansprüchen.

Beim erfindungsgemäßen Verfahren wird auf einem aus dem Stand der Technik bekannten SOI-Wafer mindestens eine elektromagnetische Strahlung emittierenden Schicht auf der Vorderseite des SOI-Wafers abgeschieden. Diese mindestens eine elektromagnetische Strahlung emittierende Schicht ist vorzugsweise als organische Schicht ausgebildet, kann alternativ aber auch eine anorganische Schicht sein. Damit bei einem Display die elektromagnetische Strahlung emittierende Schicht auch elektromagnetische Strahlung emittieren kann, sind an die Schicht angrenzende Pixelelektroden und an die Schicht angrenzende Pixelgenelektroden erforderlich.

Bei einer Ausführungsform der Erfindung werden die Pixelelektroden und Pixelgegenelektroden für die mindestens eine elektromagnetische Strahlung emittierende Schicht innerhalb einer Ebene angeordnet und als Bestandteil des SOI-Wafers ausgebildet.

Alternativ können auch nur die Pixelelektroden als Bestandteil des SOI-Wafers ausgebildet werden, wobei dann zusätzlich auch noch eine elektrisch leitfähige Schicht oberhalb angrenzend an die mindestens eine elektromagnetische Strahlung emittierende Schicht abgeschieden wird, welche als Gegenelektrode fungiert. Diese elektrisch leitfähige Schicht kann alternativ auch als Teilschicht ausgebildet und oberer Bestandteil der mindestens einen elektromagnetische Strahlung emittierenden Schicht sein. Bei einer weiteren Ausführungsform wird die elektrisch leitfähige Schicht bzw. elektrisch leitfähige Teilschicht strukturiert, so dass jedem Pixel mindestens eine Pixelgegenelektrode zugeordnet werden kann.

Es ist bekannt, dass organische, elektromagnetische Strahlung emittierende Schichten oftmals aus einer Vielzahl von Teilschichten bestehen, die auch beim erfindungsgemäßen Verfahren als organische Schicht abgeschieden werden können. Lediglich beispielhaft seien nachfolgend einige dieser Teilschichten, die solch eine Schicht umfassen kann, mit ihren englischsprachigen Fachbegriffen und zugehörigen Kürzeln in Klammern, ohne Anspruch auf Vollständigkeit, aufgezählt: Lochinjektionsschicht (Hole Injection Layer, HIL), Lochleitungsschicht (Hole Transport Layer, HTL), Elektronenblockerschicht (Electron Blocking Layer, EBL), Emissionsschicht (Emission Layer, EML), Lochblockerschicht (Hole Blocking Layer, HBL), Elektronenleitungsschicht (Electron Transport Layer, ETL).

Anschließend wird noch mindestens eine transparente Deckschicht oberhalb der mindestens einen, elektromagnetische Strahlung emittierenden Schicht aufgetragen. Die transparente Deckschicht kann beispielsweise als Glas oder Kunststofffolie ausgebildet werden. Als Zwischenprodukt entsteht auf diese Weise ein Verbund, mindestens umfassend den SOI-Wafer, die elektromagnetische Strahlung emittierende Schicht und die transparente Deckschicht. Zwischen dem SOI-Wafer, der elektromagnetische Strahlung emittierenden Schicht und der transparenten Deckschicht können aber auch noch weitere Schichten wie beispielsweise Barriereschichten oder Haftvermittlerschichten abgeschieden sein.

Erfindungsgemäß wird das Silizium-Substrat des SOI-Wafers vom Verbund entfernt, wodurch ein Restverbund entsteht. Das Silizium-Substrat kann beispielsweise mit mechanischen Mitteln vom Verbund abgeschliffen und/oder mittels chemischer Substanzen vom Verbund entfernt werden. Das Silizium-Substrat, welches vorwiegend wegen der mechanischen Stabilität am SOI-Wafer vorhanden war, ist für die mechanische Stabilität des Restverbundes eines erfindungsgemäßen Displays nicht erforderlich, weil die Deckschicht, welche beispielsweise als Glas oder als Kunststofffolie ausgebildet sein kann, eine hinreichende mechanische Stabilität des Restverbundes ohne Silizium-Substrat gewährleistet.

Das Entfernen des Silizium-Substrates vom Verbund bewirkt außerdem, dass der Restverbund ohne Silizium-Substrat semitransparent wird. Das bedeutet, dass zumindest in den Bereichen des Restverbundes, in denen keine Transistoren bzw. keine elektrischen Schaltungen und keine elektrisch leitfähige Verbindung ausgebildet ist, Licht, welches von einem menschlichen Auge erfassbar ist, von beiden Seiten durch den Restverbund hindurchstrahlen kann, was vor dem Entfernen des Silizium-Substrates durch das Silizium-Substrat verhindert wurde.

Nach dem Entfernen des Silizium-Substrates vom SOI-Wafer kann bei einem Ausführungsbeispiel eine nicht transparente Schicht auf der Rückseite des Rest-SOI-Wafers abgeschieden und strukturiert werden, um beispielsweise rückseitig ankommende und störend wirkende elektromagnetische Strahlung auf die Pixelschaltung abzuschirmen. In Bereichen außerhalb der Pixelschaltung bleibt hierbei die Transparenz erhalten.

Nachdem das Silizium-Substrat vom Verbund entfernt wurde wird erfindungsgemäß ein Verdrahtungsträger an der Vorderseite oder an der Rückseite des Restverbundes befestigt. Ein Verdrahtungsträger kann beispielsweise als Leiterplatte ausgebildet sein.

Wird der Verdrahtungsträger an der Vorderseite des Restverbundes befestigt, von der im Pixelbereich elektromagnetische Strahlung emittiert wird, so weist der Verdrahtungsträger zumindest im Pixelbereich eine Ausnehmung auf.

Erfindungsgemäß werden elektrisch leitfähige Verbindungen zwischen dem Kontaktbereich des ehemaligen SOI-Wafers, der nun nur noch teilweise Bestandteil des Restverbundes ist, und des Verdrahtungsträgers von der Rückseite des SOI-Wafers her ausgebildet. Dies ist jetzt möglich, weil zuvor das Silizium-Substrat entfernt wurde, wodurch nun innerhalb des Kontaktbereiches mit bekannten Verfahrensschritten Kontaktelemente bzw. elektrisch leitfähige Elemente, vornehmlich aus der untersten Verdrahtungsebene, rückseitig freigelegt werden können. Ist der Verdrahtungsträger an der Vorderseite des Restverbundes befestigt, können elektrisch leitfähige Verbindungen zwischen dem Kontaktbereich und dem Verdrahtungsträger beispielsweise als Drahtbond ausgebildet werden. Ist der Verdrahtungsträger an der Rückseite des Restverbundes befestigt, können elektrisch leitfähige Verbindungen zwischen dem Kontaktbereich und dem Verdrahtungsträger beispielsweise als Bump-Bond oder anisotrop leitfähige Klebestelle ausgebildet werden.

Die Erfindung wird nachfolgend an Ausführungsbeispielen näher beschrieben. Die Fig. zeigen:
- Fig. 1: eine schematische Schnittdarstellung eines für einen Displayaufbau geeigneten SOI- Wafer,
- Fig. 2: eine schematische Schnittdarstellung eines SOI-Wafers, auf welchem eine elektrische Strahlung emittierende Schicht abgeschieden und eine Deckschicht aufgetragen sind,
- Fig. 3: eine schematische Schnittdarstellung des Verbundes aus Fig. 2, von welchem das Silizium-Substrat entfernt ist,
- Fig. 4: eine schematische Schnittdarstellung des Restverbundes aus Fig. 3, an welchem elektrisch leitfähige Elemente freigelegt sind,
- Fig. 5: eine schematische Schnittdarstellung des Restverbundes aus Fig. 4, an welchem vorderseitig ein Verdrahtungsträger befestigt ist,
- Fig. 6: eine schematische Schnittdarstellung des Restverbundes aus Fig. 4, an welchem rückseitig ein Verdrahtungsträger befestigt ist,
- Fig. 7: eine rückseitige schematische Darstellung eines Restverbundes, an welchem vorderseitig ein Verdrahtungsträger befestigt ist.

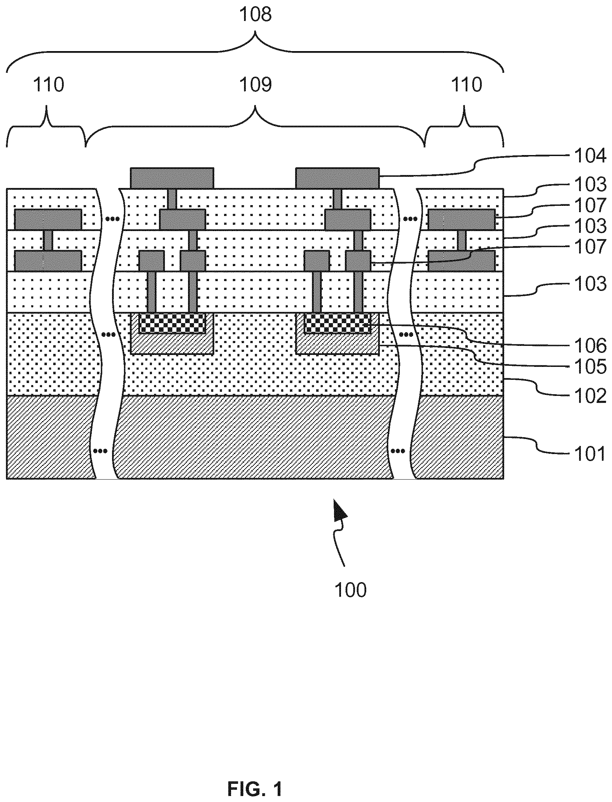

Ein aus dem Stand der Technik bekannter für einen Displayaufbau geeigneter SOI-Wafer 100 ist in Fig. 1 schematisch als Schnitt dargestellt. Der SOI-Wafer 100 umfasst der Reihenfolge nach betrachtet zunächst ein rückseitiges Silizium-Substrat 101, eine transparente Schicht 102 aus einem elektrisch nicht leitenden Material, sowie mehrere transparente Siliziumoxidschichten 103, an deren Oberfläche als Pixelelektroden fungierende Kontakte 104 ausgebildet sind. Innerhalb der Schicht 102 aus elektrisch nicht leitendem Material ist eine Vielzahl von siliziumbasierten Aktivgebieten 105 eingelassen, innerhalb denen elektrische Schaltungen 106 zum Ansteuern von Pixelzellen ausgebildet sind. Innerhalb der Siliziumoxidschichten 103 sind ferner elektrisch leitfähige Elemente 107 ausgebildet, welche sich beispielsweise zwischen Anschlüssen der Schaltungen 106 und/oder von den Anschlüssen der Schaltungen 106 zu den Kontakten 104 hin erstrecken.

Der in Fig. 1 dargestellte Aufbau eines SOI-Wafers ist lediglich beispielhaft. Alternativ kann ein aus dem Stand der Technik bekannter SOI-Wafer auch einen anderen Aufbau aufweisen. So können Aktivgebiete eines SOI-Wafers beispielsweise nicht innerhalb der Schicht 102 sondern auf der Schicht 102 ausgebildet sein. Es sei somit angemerkt, dass alle aus dem Stand der Technik bekannten SOI-Wafer, die für den Aufbau eines Displays geeignet sind auch für das erfindungsgemäße Verfahren und für den Aufbau eines erfindungsgemäßen Displays verwendet werden können.

Der SOI-Wafer 100 ist unterteilt in einen Pixelbereich 109 und einen Kontaktbereich 110. Im Ausführungsbeispiel von Fig. 1 umschließt der Kontaktbereich 110 den Pixelbereich 109 vollständig. Der Übersichtlichkeit wegen ist in den Schnittdarstellungen der Fig. 1 bis 6 nur ein Auszug aus dem Pixelbereich eines SOI-Wafers 100 dargestellt, welcher lediglich zwei siliziumbasierte Aktivgebiete 105 umfasst. Bei einem vollständigen Pixelbereich können hingegen mehrere tausend solcher siliziumbasierten Aktivgebiete 105 nebeneinander angeordnet sein.

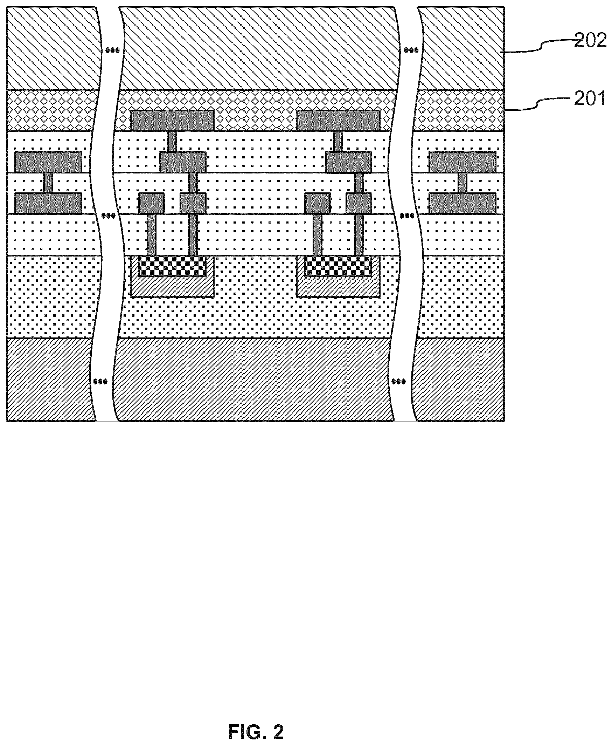

In Fig. 2 ist schematisch im Schnitt dargestellt, dass erfindungsgemäß auf einen SOI-Wafer zunächst mit bekannten Verfahrensschritten eine transparente, elektromagnetische Strahlung emittierende Schicht 201 abgeschieden und anschließend eine transparente Deckschicht 202, welche im Ausführungsbeispiel aus Glas besteht, aufgetragen werden, wodurch ein Verbund bestehend aus SOI-Wafer 100, Schicht 201 und Deckschicht 202 entsteht. Die elektromagnetische Strahlung emittierende Schicht 201 ist im Ausführungsbeispiel als organische Schicht ausgebildet und besteht aus einer Vielzahl von bekannten Teilschichten, wie es zuvor schon einmal beschrieben wurde. Ferner umfasst die Schicht 201 als oberen Abschluss eine Teilschicht aus einem elektrisch leitfähigen Material, wobei die Teilschicht aus dem elektrisch leitfähigen Material entsprechend der Pixelanordnung des entstehenden Displays strukturiert ist und als Pixelgegenelektrode fungiert.

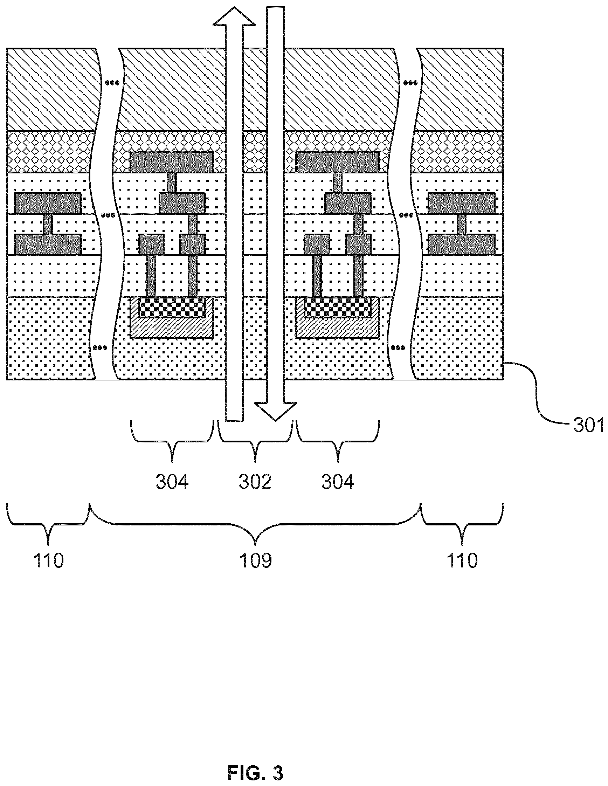

Erfindungsgemäß wird nach dem Herstellen des Verbundes aus SOI-Wafer 100, Schicht 201 und Deckschicht 202 das Silizium-Substrat 101 des ursprünglichen SOI-Wafers 100 vom Verbund entfernt. Dadurch entsteht ein Restverbund 301 , welcher in Fig. 3 schematisch als Schnitt dargestellt ist und welcher semitransparent ist. Das bedeutet, der Restverbund 301 ist zumindest innerhalb des Pixelbereiches 109 in den Teilbereichen 302, in denen keine Schaltungselemente und keine elektrisch leitfähigen Elemente ausgebildet sind, von beiden Seiten her transparent bezüglich Licht, welches mit einem menschlichen Auge erfassbar ist, wie es mit den beiden Pfeilen in Fig. 3 schematisch dargestellt ist. Ferner weist der Restverbund 301 aber auch weiterhin Teilbereiche auf, wie beispielsweise die Kontaktbereiche 110 und die Teilbereiche 303 des Pixelbereichs 109, innerhalb denen Schaltungselemente und/oder elektrisch leitfähige Elemente ausgebildet sind und welche somit eine geringere Transparenz gegenüber den Teilbereichen 302 aufweisen.

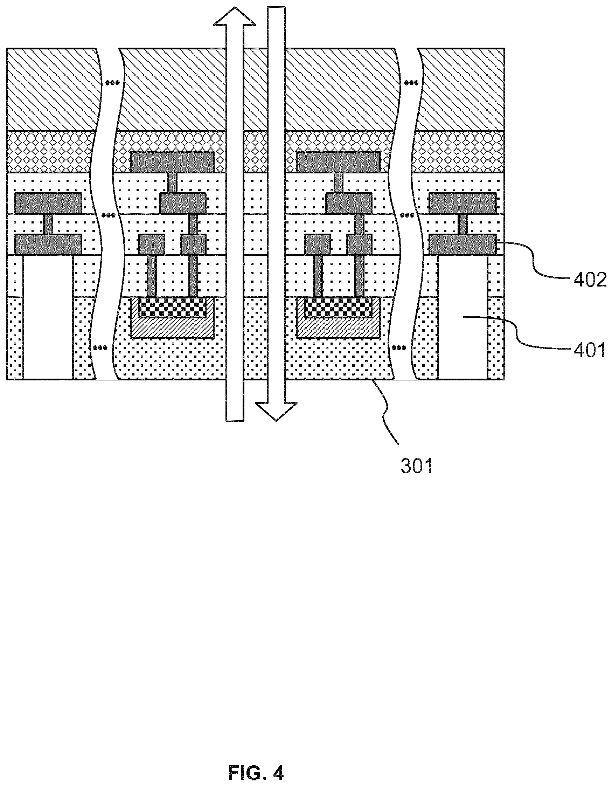

Neben der entstehenden Semitransparenz des Restverbundes 301 geht mit dem Entfernen des Silizium-Substrates 100 vom Verbund noch ein weiterer Vorteil einher. Jetzt ist es möglich am Restverbund 301 rückseitig mit bekannten Verfahrensschritten Vertiefungen 401 einzubringen, welche innerhalb des Kontaktbereiches 110 elektrisch leitfähige Elemente 402 der untersten Verdrahtungsebene freilegen, wie es in Fig. 4 schematisch als Schnitt dargestellt ist.

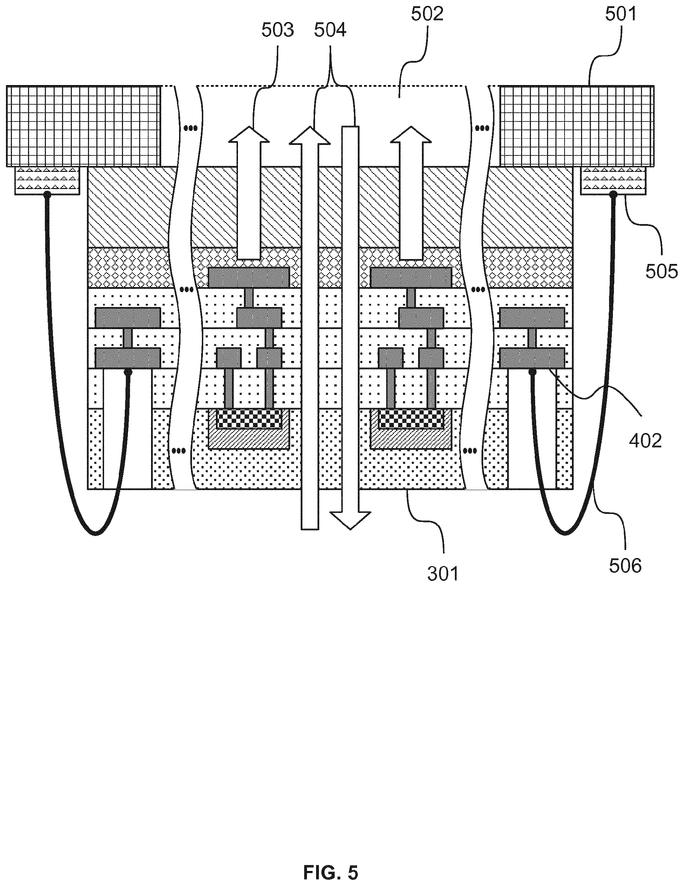

In Fig. 5 ist in einem Schnitt schematisch dargestellt, wie ein Verdrahtungsträger 501 an der Vorderseite des Restverbundes 301 befestigt ist. Der Verdrahtungsträger 501 weist im Pixelbereich des Restverbundes 301 eine Ausnehmung 502 auf, durch welche elektromagnetische Strahlung 503 der Displaypixel sowie den Restverbund 301 durchdringendes Licht 508 hindurchstrahlen kann. Des Weiteren ist in Fig. 5 aufgezeigt, dass Kontaktelemente 505 eines vorderseitig befestigten Verdrahtungsträgers 501 , beispielsweise mittels Drahtbonds 506, mit den rückseitig freigelegten elektrisch leitfähigen Elementen 402 kontaktiert werden können.

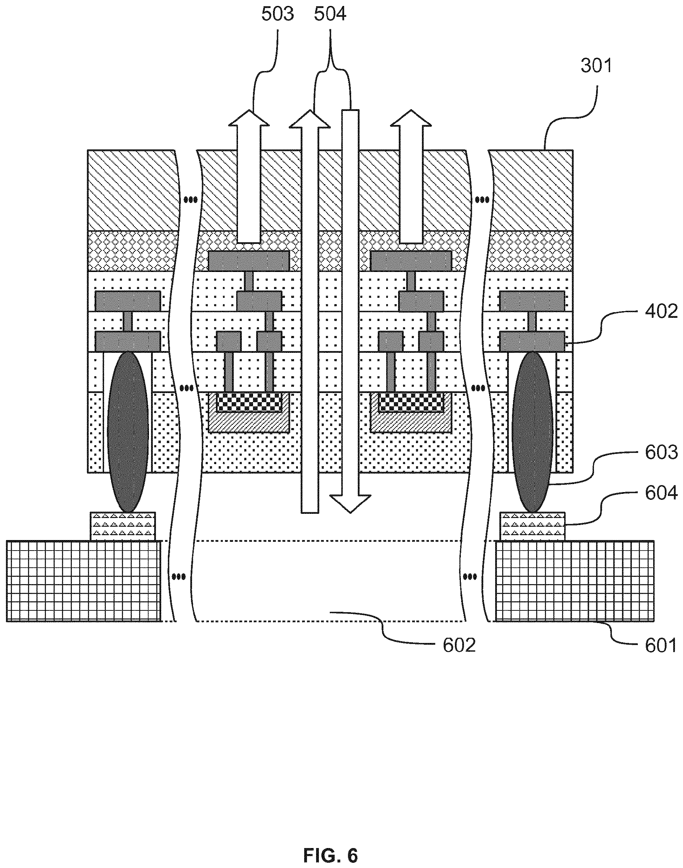

Ein alternativer erfindungsgemäßer Displayaufbau ist in Fig. 6 schematisch als Schnitt dargestellt. An dem aus Fig. 4 bekannten Restverbund 301 wurde bei einer alternativen Vorgehensweise diesmal rückseitig ein Verdrahtungsträger 601 befestigt. Auch der Verdrahtungsträger 601 weist im Pixelbereich des Restverbundes 301 eine Ausnehmung 602 auf. Alternativ kann bei einem rückseitig befestigen Verdrahtungsträger auch keine Ausnehmung im Pixelbereich vorhanden sein, wenn die Eigenschaft der Semitransparenz bei einem Display nicht erforderlich ist. Die rückseitig freigelegten elektrisch leitfähigen Elemente 402 des Restverbundes 301 sind bei dem Ausführungsbeispiel aus Fig. 6 mittels sogenannter Bump-Bonds 603 mit Kontaktelementen 604 des Verdrahtungsträgers 601 elektrisch leitfähig verbunden.

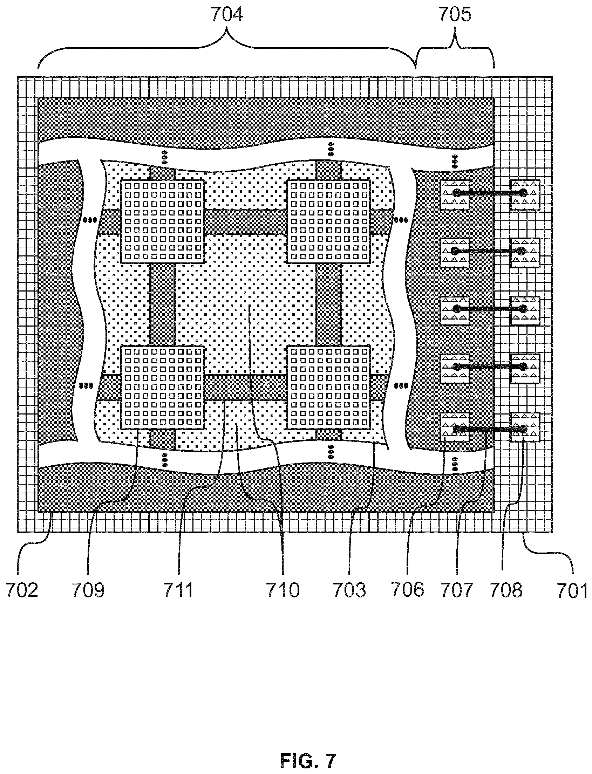

In Fig. 7 ist schließlich noch einmal ein erfindungsgemäßer Displayaufbau schematisch in einer Sicht von der Rückseite dargestellt, bei welchem ein Verdrahtungsträger 701 an der Vorderseite eines Restverbundes 702 befestigt ist, wobei ein Detailausschnitt 703 eines Pixelbereiches 704 des Restverbundes 702 zur besseren Veranschaulichung stark vergrößert dargestellt ist. Der Restverbund 702 weist neben dem Pixelbereich 704 auch einen Kontaktbereich 705 auf. Rückseitig freigelegte, elektrisch leitfähige Elemente 706 innerhalb des Kontaktbereichs 705 sind mittels Drahtbonds 707 mit Kontaktelementen 708 des Verdrahtungsträgers 701 elektrisch leitfähig verbunden.

Im Detailausschnitt 703 sind wegen der besseren Übersichtlichkeit lediglich vier Pixel 709 schematisch dargestellt. Der Detailausschnitt 703 soll noch einmal veranschaulichen, dass es bei einem erfindungsgemäßen Display zwischen den Pixeln 709 eine Vielzahl von Teilbereichen 710 gibt, innerhalb denen keine Schaltungen zum Ansteuern der Pixel 709 und auch keine elektrisch leitfähigen Verbindungen 711 ausgebildet sind, weshalb die Teilbereiche 710 transparent sind. Da die Oberflächenbereiche eines erfindungsgemäßen Displays, innerhalb denen, zum Beispiel Schaltungen oder Elektroden zum Ansteuern von Pixeln 709 oder elektrisch leitfähige Verbindungen 711 ausgebildet sind, eine zumindest geringere oder sogar stark eingeschränkte Transparenz gegenüber den Teilbereichen 710 aufweisen, wird ein erfindungsgemäßes Display als semitransparent bezeichnet.

Im Folgenden werden zusätzliche Ausführungsbeispiele und Aspekte der Erfindung beschrieben, die einzeln oder in Kombination mit beliebigen der hierin beschriebenen Merkmale, Funktionalitäten und Einzelheiten verwendet werden können.

Gemäß einem ersten Aspekt weist ein Verfahren zum Herstellen eines semitransparenten Displays folgende Verfahrensschritte auf:
a) Bereitstellen eines SOI-Wafers 100, dessen Oberfläche mindestens einen Pixelbereich 109 und mindestens einen neben dem Pixelbereich 109 angeordneten Kontaktbereich 110 aufweist, wobei der SOI-Wafer 100 auf der Rückseite ein Silizium-Substrat 101 umfasst;
b) Abscheiden mindestens einer, elektromagnetische Strahlung emittierenden Schicht 201 auf der Vorderseite des SOI-Wafers 100;
c) Auftragen mindestens einer transparenten Deckschicht 202 oberhalb der mindestens einen, elektromagnetische Strahlung emittierenden Schicht 201
d) Befestigen eines Verdrahtungsträgers 501; 601 an dem Verbund, welcher mindestens umfasst, den SOI-Wafer 100, die elektromagnetische Strahlung emittierende Schicht 201 und die transparente Deckschicht 202,
dadurch gekennzeichnet, dass vor dem Befestigen des Verdrahtungsträgers 501; 601 an dem Verbund, bestehend aus dem SOI-Wafer 100, der elektromagnetische Strahlung emittierenden Schicht 201 und der transparenten Deckschicht 202, das Silizium-Substrat 101 vom Verbund entfernt wird, wodurch ein Restverbund 301 entsteht und elektrisch leitfähige Verbindungen zwischen dem Kontaktbereich 110 des SOI-Wafers 100 und des Verdrahtungsträgers 501; 601 von der Rückseite des SOI-Wafers 100 her ausgebildet werden.

Gemäß einem zweiten Aspekt unter Bezugnahme auf den ersten Aspekt ist das Verfahren dadurch gekennzeichnet, dass der Verdrahtungsträger 501 an der Vorderseite des Restverbundes 301 befestigt wird.

Gemäß einem dritten Aspekt unter Bezugnahme auf den zweiten Aspekt ist das Verfahren dadurch gekennzeichnet, dass elektrisch leitfähige Verbindungen zwischen dem Kontaktbereich 110 des SOI-Wafers 100 und dem Verdrahtungsträger 501 als Drahtbond 506 ausgebildet werden.

Gemäß einem vierten Aspekt unter Bezugnahme auf den ersten Aspekt wird der Verdrahtungsträger 601 an der Rückseite des Restverbundes 301 befestigt.

Gemäß einem fünften Aspekt unter Bezugnahme auf den vierten Aspekt ist das Verfahren dadurch gekennzeichnet, dass elektrisch leitfähige Verbindungen zwischen dem Kontaktbereich 110 des SOI-Wafers und dem Verdrahtungsträger 601 als Bump-Bond 603 oder anisotrop leitfähige Klebestelle ausgebildet werden.

Gemäß einem sechsten Aspekt unter Bezugnahme auf zumindest einen des ersten bis fünften Aspekts ist das Verfahren dadurch gekennzeichnet, dass die mindestens eine, elektromagnetische Strahlung emittierende Schicht 201 als organische Schicht ausgebildet wird.

Gemäß einem siebten Aspekt unter Bezugnahme auf zumindest einen des ersten bis fünften Aspekts ist das Verfahren dadurch gekennzeichnet, dass die mindestens eine, elektromagnetische Strahlung emittierende Schicht als anorganische Schicht ausgebildet wird.

Gemäß einem achten Aspekt unter Bezugnahme auf zumindest einen des ersten bis siebten Aspekts ist das Verfahren dadurch gekennzeichnet, dass das Silizium-Substrat 101 vom Verbund mechanisch abgeschliffen wird und/oder dass das Silizium-Substrat 101 mittels chemischer Substanzen vom Verbund entfernt wird.

Gemäß einem neunten Aspekt unter Bezugnahme auf zumindest einen des ersten bis achten Aspekts ist das Verfahren dadurch gekennzeichnet, dass die mindestens eine transparente Deckschicht 202 als Glas oder Kunststofffolie ausgebildet wird.

Gemäß einem zehnten Aspekt unter Bezugnahme auf zumindest einen des ersten bis neunten Aspekts ist das Verfahren dadurch gekennzeichnet, dass Pixelelektroden und Pixelgegenelektroden für die mindestens eine elektromagnetische Strahlung emittierende Schicht innerhalb einer Ebene angeordnet und als Bestandteil des SOI-Wafers ausgebildet werden.

Gemäß einem elften Aspekt unter Bezugnahme auf zumindest einen des ersten bis neunten Aspekts ist das Verfahren dadurch gekennzeichnet, dass Pixelelektroden 104 als Bestandteil des SOI-Wafers ausgebildet werden, wobei eine elektrisch leitfähige Schicht oberhalb angrenzend an die mindestens eine elektromagnetische Strahlung emittierende Schicht oder als oberer Bestandteil der elektrisch leitfähigen Schicht abgeschieden wird.

Gemäß einem zwölften Aspekt unter Bezugnahme auf den elften Aspekt ist das Verfahren dadurch gekennzeichnet, dass die elektrisch leitfähige Schicht strukturiert wird.

Gemäß einem dreizehnten Aspekt umfasst ein semitransparentes Display:
a) einen Restverbund 301, umfassend einen SOI-Wafer 100, dessen Oberfläche mindestens einen Pixelbereich 109 und mindestens einen neben dem Pixelbereich 109 angeordneten Kontaktbereich 110 aufweist, wobei ein Silizium-Substrat 101 von der Rückseite des SOI-Wafers 100 entfernt ist;
b) mindestens eine auf der Vorderseite des SOI-Wafers abgeschiedene, elektromagnetische Strahlung emittierende Schicht 201;
c) mindestens eine, oberhalb der mindestens einen, elektromagnetische Strahlung emittierenden Schicht 201 aufgetragene transparente Deckschicht 202;
d) ein am Restverbund 301 befestigter Verdrahtungsträger 501; 601, dadurch gekennzeichnet, dass elektrisch leitfähige Verbindungen zwischen dem Kontaktbereich 110 des SOI-Wafers 100 und dem Verdrahtungsträger 501; 601 von der Rückseite des SOI-Wafers 100 her ausgebildet sind.

## Patentansprüche

1. Semitransparentes Display, umfassend:
einen Restverbund, der einen Silizium-auf-Isolator-Wafer (SOI-Wafer) mit einem Pixelbereich und einem neben dem Pixelbereich angeordneten Kontaktbereich aufweist, wobei das Silizium-Substrat des SOI-Wafers von einer Rückseite des SOI-Wafers entfernt ist;
eine auf einer Vorderseite des SOI-Wafers abgeschiedene elektromagnetische Strahlung emittierende Schicht;
eine oberhalb der elektromagnetische Strahlung emittierenden Schicht aufgetragene transparente Deckschicht;
einen Verdrahtungsträger, wobei der Verdrahtungsträger eine Leiterplatte mit einer Ausnehmung mindestens in dem Pixelbereich aufweist; und
eine Vielzahl von elektrisch leitfähigen Verbindungen, die zwischen dem Kontaktbereich des SOI-Wafers und dem Verdrahtungsträger von der Rückseite des SOI-Wafers angeordnet sind und einen Bump-Bond oder ein Drahtbond oder eine anisotrop leitfähige Klebestelle aufweisen;
wobei der Pixelbereich eine Vielzahl von Teilbereichen aufweist, in denen sich keine Schaltungselemente und keine elektrisch leitfähigen Elemente befinden, wobei ferner die Teilbereiche erlauben, dass Licht, welches mit einem menschlichen Auge erfassbar ist, von einer Vorderseite der semitransparenten Anzeige zu einer Rückseite der semitransparenten Anzeige hindurchstrahlen kann.

2. Semitransparentes Display, umfassend:
einen Restverbund,
einen Pixelbereich und einen neben dem Pixelbereich angeordneten Kontaktbereich,
mindestens eine eine elektromagnetische Strahlung emittierende Schicht und
mindestens eine oberhalb der die elektromagnetische Strahlung emittierenden Schicht aufgetragene transparente Deckschicht;
einen Verdrahtungsträger, der als Leiterplatte ausgebildet ist und zumindest im Pixelbereich eine Ausnehmung aufweist; und
eine Vielzahl von elektrisch leitfähigen Verbindungen zwischen dem Kontaktbereich und dem Verdrahtungsträger, die von der Rückseite des Restverbundes her ausgebildet sind und als Bump-Bonds oder als ein Drahtbond oder als eine anisotrop leitfähige Klebestelle ausgebildet sind,
wobei der Restverbund zumindest innerhalb des Pixelbereichs Teilbereiche aufweist, in denen keine Schaltungselemente und keine elektrisch leitfähigen Elemente ausgebildet sind, so dass Licht, welches mit einem menschlichen Auge erfassbar ist, von beiden Seiten durch den Restverbund hindurchstrahlen kann.

3. Semitransparente Anzeige gemäß Anspruch 1 oder 2, wobei die elektromagnetische Strahlung emittierende Schicht eine organische Schicht ist.

4. Semitransparente Anzeige gemäß Anspruch 1 oder 2, wobei die elektromagnetische Strahlung emittierende Schicht eine anorganische Schicht ist.

5. Semitransparente Anzeige gemäß einem der Ansprüche 1 bis 4, wobei die transparente Deckschicht Glas oder Kunststofffolie ist.

6. Semitransparente Anzeige gemäß einem der Ansprüche 1 bis 5, die ferner Pixelelektroden und Pixelgegenelektroden für die elektromagnetische Strahlung emittierende Schicht auf einer Ebene aufweist, wobei die Pixelelektroden oder Pixelgegenelektroden als Bestandteil des SOI-Wafers enthalten sind.

7. Semitransparente Anzeige gemäß einem der Ansprüche 1 bis 6, die ferner eine Vielzahl von Pixelelektroden und eine elektrisch leitfähige Schicht aufweist, wobei die Pixelelektroden in dem SOI-Wafer enthalten sind und die eine elektrisch leitfähige Schicht oberhalb und angrenzend an die elektromagnetische Strahlung emittierende Schicht angeordnet ist.

8. Semitransparente Anzeige gemäß Anspruch 7, wobei die elektrisch leitfähige Schicht strukturiert ist.

9. Semitransparente Anzeige gemäß Anspruch 7 oder 8, die ferner eine Vielzahl von Pixelelektroden und eine elektrisch leitfähige Schicht aufweist, wobei die Pixelelektroden in dem SOI-Wafer enthalten sind und die eine elektrisch leitfähige Schicht ein oberer Bestandteil der elektrisch leitfähigen Schicht ist.

10. Semitransparente Anzeige gemäß einem der Ansprüche 1 bis 9, wobei das von der Rückseite entfernte Siliziumsubstrat ermöglicht, dass die elektrisch leitfähigen Verbindungen an der Rückseite innerhalb des Kontaktbereichs freiliegen.

11. Semitransparente Anzeige gemäß einem der Ansprüche 1 bis 10, wobei die elektromagnetische Strahlung emittierende Schicht transparent ist; und/oder
wobei der Verdrahtungsträger an einer Rückseite oder einer Vorderseite des Restverbundes befestigt ist.

12. Semitransparente Anzeige, umfassend:
einen Restverbund, der einen Silizium-auf-Isolator-Wafer (SOI-Wafer) mit einem Pixelbereich und einem neben dem Pixelbereich angeordneten Kontaktbereich aufweist, wobei das Silizium-Substrat des SOI-Wafers von einer Rückseite des SOI-Wafers entfernt ist;
eine auf einer Vorderseite des SOI-Wafers abgeschiedene elektromagnetische Strahlung emittierende Schicht;
eine oberhalb der elektromagnetische Strahlung emittierenden Schicht aufgetragene transparente Deckschicht;
einen Verdrahtungsträger, wobei der Verdrahtungsträger eine Leiterplatte mit einer Ausnehmung mindestens in dem Pixelbereich aufweist; and
eine Vielzahl von elektrisch leitfähigen Verbindungen, die zwischen dem Kontaktbereich des SOI-Wafers und dem Verdrahtungsträger von der Rückseite des SOI-Wafers angeordnet sind, die ein Drahtbond oder Bump-Bond aufweisen;
wobei der Pixelbereich eine Vielzahl von Teilbereichen aufweist, in denen sich keine Schaltungselemente und keine elektrisch leitfähigen Elemente befinden, wobei ferner die Teilbereiche erlauben, dass Licht, welches mit einem menschlichen Auge erfassbar ist, von einer Vorderseite der semitransparenten Anzeige zu einer Rückseite der semitransparenten Anzeige hindurchstrahlen kann.

13. Semitransparente Anzeige gemäß Anspruch 12, wobei die elektromagnetische Strahlung emittierende Schicht eine organische Schicht ist oder wobei die elektromagnetische Strahlung emittierende Schicht eine anorganische Schicht ist; und/oder
wobei die transparente Deckschicht Glas oder Kunststofffolie ist.

14. Semitransparente Anzeige gemäß einem der Ansprüche 12 bis 13, die ferner Pixelelektroden und Pixelgegenelektroden für die elektromagnetische Strahlung emittierende Schicht auf einer Ebene aufweist, wobei die Pixelelektroden oder Pixelgegenelektroden als Bestandteil des SOI-Wafers enthalten sind; und/oder
die ferner eine Vielzahl von Pixelelektroden und eine elektrisch leitfähige Schicht aufweist, wobei die Pixelelektroden in dem SOI-Wafer enthalten sind und die eine elektrisch leitfähige Schicht oberhalb und angrenzend an die elektromagnetische Strahlung emittierende Schicht angeordnet ist.

15. Semitransparente Anzeige gemäß Anspruch 14, die ferner eine Vielzahl von Pixelelektroden und eine elektrisch leitfähige Schicht aufweist, wobei die Pixelelektroden in dem SOI-Wafer enthalten sind und die eine elektrisch leitfähige Schicht ein oberer Bestandteil der elektrisch leitfähigen Schicht ist.
